# EUROPEAN PATENT APPLICATION

(11) **EP 4 116 449 A1**
(43) Date of publication of application: **11.01.2023**
(21) Application number: 21764614.0
(22) Date of filing: 05.03.2021
(51) Int. Cl.: C22C 9/00, C22F 1/00, C22F 1/08

(54) **PURE COPPER PLATE, COPPER/CERAMIC JOINED BODY, AND INSULATED CIRCUIT SUBSTRATE**

(30) Priority: 06.03.2020 JP 2020038763
(71) Applicant: Mitsubishi Materials Corporation, Tokyo 100-8117 (JP)
(72) Inventor: MATSUNAGA, Hirotaka, Kitamoto-shi, Saitama 364-0028 (JP); ITO, Yuki, Saitama-shi, Saitama 330-8508 (JP); MORI, Hiroyuki, Kitamoto-shi, Saitama 364-0028 (JP)
(74) Representative: Hoffmann Eitle
(86) International application number: PCT/JP2021/008812
(87) International publication number: WO 2021/177461

(57) **Abstract**

A pure copper sheet of the present invention has a composition including 99.96 mass% or more of Cu, 10.0 mass ppm or less of a total content of Pb, Se, and Te, 3.0 mass ppm or more of a total content of Ag and Fe, and inevitable impurities as a balance, in which an average crystal grain size of crystal grains on a rolled surface is 10 µm or more, an aspect ratio of the crystal grain on the rolled surface is 2.0 or less, and an average crystal grain size of the crystal grains on the rolled surface after a pressure heat treatment performed under conditions of a pressure of 0.6 MPa, a heating temperature of 850°C, and a retention time at the heating temperature of 90 minutes is 500 µm or less.

## Description

### TECHNICAL FIELD

The present invention relates to a pure copper sheet suitable for electrical and electronic components such as heat sinks or thick copper circuits, in particular, a pure copper sheet in which coarsening of crystal grains during pressure heat treatments is suppressed, a copper/ceramic bonded body and an insulated circuit substrate for which this pure copper sheet is used.

Priority is claimed on Japanese Patent Application No. 2020-038763, filed March 6, 2020, the content of which is incorporated herein by reference.

### BACKGROUND ART

Conventionally, highly conductive copper or copper alloy has been used for electrical and electronic components such as heat sinks or thick copper circuits.

Recently, in response to an increase in the current in electronic devices, electric devices, or the like, attempts have been made to increase the sizes and thicknesses of electrical and electronic components that are used in these electronic devices, electric devices, or the like in order for a decrease in the current density and the diffusion of heat attributed to Joule heat generation.

Here, in semiconductor devices, for example, an insulated circuit substrate or the like in which a copper material is bonded to a ceramic substrate to form the above-described heat sink or thick copper circuit is used.

At the time of bonding the ceramic substrate and a copper sheet, the bonding temperature is often set to 800°C or higher, and there is a concern that the crystal grains of the copper material that forms the heat sink or the thick copper circuit may become coarse during bonding. Particularly, in copper materials made of pure copper that is particularly excellent in terms of the conductivity and the heat radiation, there is a tendency that crystal grains are likely to become coarse.

In a case where the crystal grains become coarse in the heat sink or the thick copper circuit after bonding, there is a concern that a problem may be caused in terms of the appearance due to the coarsening of the crystal grains.

Here, for example, Patent Document 1 proposes a pure copper sheet material in which the growth of crystal grains is suppressed. Patent Document 1 describes that, when 0.0006 to 0.0015 wt% of S is contained, it is possible to adjust the crystal grains to a certain size even when a heat treatment is performed at a recrystallization temperature or higher.

### [Citation List]

### [Patent Document]

[Patent Document 1]
Japanese Unexamined Patent Application, First Publication No. H06-002058

### SUMMARY OF INVENTION

### Technical Problem

Incidentally, at the time of firmly bonding a ceramic substrate and a copper sheet, a heat treatment is performed at a high temperature in a state where the ceramic substrate and the copper sheet are pressurized at a relatively high pressure (for example, 0.1 MPa or more) in the stacking direction. At this time, in the pure copper sheet, the crystal grains are likely to grow more nonuniformly, and the coarsening or nonuniform growth of the crystal grains may cause poor bonding, poor appearance, or defects in the inspection step. In order to solve this problem, in pure copper sheets, there is a demand that a change in the crystal grain sizes is small and the sizes are uniform even after a pressure heat treatment for bonding with a material of a different kind.

Here, in Patent Document 1, the coarsening of the crystal grains is suppressed by specifying the content of S; however, there is a case where it is not possible to obtain a sufficient crystal grain coarsening-suppressing effect after a pressure heat treatment only by specifying the content. In addition, there is a case where, after the pressure heat treatment, the crystal grains locally become coarse and the crystal structure becomes nonuniform.

Furthermore, in the case of increasing the content of S in order to suppress the coarsening of the crystal grains, there is a problem in that the hot workability significantly deteriorates and the manufacturing yield of pure copper sheets significantly deteriorates.

The present invention has been made in view of the above-described circumstances, and an objective of the present invention is to provide a pure copper sheet that is excellent in terms of hot workability and is capable of suppressing crystal grains becoming coarse and nonuniform even after a pressure heat treatment and a copper/ceramic bonded body and an insulated circuit substrate for which this pure copper sheet is used.

### Solution to Problem

In order to solve this problem, the present inventors performed intensive studies and found the following fact. Among impurity elements contained in a small amount in a pure copper sheet, there is an element having a crystal grain growth-suppressing effect of suppressing the coarsening of crystal grains by being present at crystal grain boundaries. Therefore, it was found that it is possible to suppress the crystal grains becoming coarse or nonuniform even after a pressure heat treatment by utilizing this element having the crystal grain growth-suppressing effect (hereinafter, referred to as the crystal grain growth-suppressing element). In addition, it was found that, in order to make the action of this crystal grain growth-suppressing element sufficiently exhibited, it is effective to regulate the content of a specific element.

Furthermore, it was found that it is effective to make the grain sizes of crystal grains relatively large in order to suppress the driving force for crystal growth during a pressure heat treatment and to control the aspect ratios of crystals in order to suppress the strain energy accumulated in materials at a low level.

The present invention has been made based on the above-described findings, and a pure copper sheet of the present invention has a composition including 99.96 mass% or more of Cu, 10.0 mass ppm or less of a total content of Pb, Se, and Te, 3.0 mass ppm or more of a total content of Ag and Fe, and inevitable impurities as a balance, in which an average crystal grain size of crystal grains on a rolled surface is 10 µm or more, and an aspect ratio of the crystal grain on the rolled surface is 2.0 or less, and an average crystal grain size of the crystal grains on the rolled surface after a pressure heat treatment is performed under conditions of a pressure of 0.6 MPa, a heating temperature of 850°C, and a retention time at the heating temperature of 90 minutes is 500 µm or less.

According to the pure copper sheet having this configuration, since the pure copper sheet has a composition in which the Cu content is set to 99.96 mass% or more, the total content of Pb, Se, and Te is set to 10.0 mass ppm or less, the total content of Ag and Fe is set to 3.0 mass ppm or more, and the balance is inevitable impurities, it becomes possible to suppress the coarsening of crystal grains by the formation of solid solutions of Ag and Fe in the matrix of copper. In addition, elements such as Pb, Se, and Te have a low solid solubility limit in Cu and are crystal grain growth-suppressing elements that are segregated in grain boundaries to suppress the coarsening of crystal grains and thus may be contained in a small amount, but these elements also have an effect of significantly degrading hot workability. Therefore, when the total content of these Pb, Se, and Te is limited to 10.0 mass ppm or less, it is possible to ensure hot workability.

In addition, since the average crystal grain size of the crystal grains on the rolled surface is 10 µm or more and the aspect ratios of the crystal grains on the rolled surface are set to 2.0 or less, before a pressure heat treatment, the grain sizes are relatively large, and the strain energy is low, and thus the driving force for recrystallization during a pressure heat treatment is small, and it becomes possible to suppress grain growth.

In addition, since the average crystal grain size of the crystal grains on the rolled surface after a pressure heat treatment performed under the conditions of a pressure of 0.6 MPa, a heating temperature of 850°C, and a retention time at the heating temperature of 90 minutes is limited to 500 µm or less, crystal growth after the pressure heat treatment is sufficiently suppressed, and it is possible to suppress the occurrence of poor bonding or poor appearance when bonded to other members.

Here, in the pure copper sheet of the present invention, it is preferable that a content of S is in a range of 2.0 mass ppm or more and 20.0 mass ppm or less.

In this case, 2.0 mass ppm or more of S, which is a crystal grain growth-suppressing element, is contained, whereby it becomes possible to reliably suppress the crystal grains becoming coarse or nonuniform even after the pressure heat treatment. In addition, when the content of S is limited to 20.0 mass ppm or less, it is possible to sufficiently ensure hot workability.

In addition, in the pure copper sheet of the present invention, it is preferable that a total content of Mg, Sr, Ba, Ti, Zr, Hf, and Y is 15.0 mass ppm or less.

Since the elements of Mg, Sr, Ba, Ti, Zr, Hf, and Y, which may be contained as inevitable impurities, generate a compound with Pb, Se, Te, S, and the like, which are crystal grain growth-suppressing elements, there is a concern that the elements may impair the action of the crystal grain growth-suppressing elements. Therefore, when the total content of Mg, Sr, Ba, Ti, Zr, Hf, and Y is limited to 15.0 mass ppm or less, it is possible to make the crystal grain growth-suppressing effect of the crystal grain growth-suppressing elements sufficiently exhibited, and it becomes possible to reliably suppress the crystal grains becoming coarse or nonuniform even after the pressure heat treatment.

Furthermore, in the pure copper sheet of the present invention, it is preferable that a ratio dₘₐₓ/dₐᵥₑ of a maximum crystal grain size dₘₐₓ to an average crystal grain size dₐᵥₑ in a range of 50 mm × 50 mm on the rolled surface after the pressure heat treatment is performed is 20.0 or less.

In this case, even after the pressure heat treatment, it is possible to reliably suppress the crystal grains becoming nonuniform, and it is possible to further suppress the occurrence of poor appearance.

Furthermore, in the pure copper sheet of the present invention, it is preferable that Vickers hardness is 150 HV or less.

In this case, since the Vickers hardness is 150 HV or less, the pure copper sheet is sufficiently soft, and characteristics as a pure copper sheet are ensured, the pure copper sheet is particularly suitable as a material for electrical and electronic components for high-current uses.

A copper/ceramic bonded body of the present invention includes the above-described pure copper sheet and a ceramic member, the pure copper sheet and the ceramic member being bonded each other.

According to the copper/ceramic bonded body having this structure, even in a case where the pure copper sheet and the ceramic member are subjected to a pressure heat treatment in order to be bonded, the crystal grains of the pure copper sheet becoming locally coarse are suppressed, and it becomes possible to suppress the occurrence of poor bonding, poor appearance, or defects in the inspection step.

A copper/ceramic bonded body of the present invention includes the above-described pure copper sheet and a ceramic member, the pure copper sheet and the ceramic member being bonded each other.

According to the insulated circuit substrate having this structure, even in a case where the pure copper sheet and the ceramic substrate are subjected to a pressure heat treatment in order to be bonded, the crystal grains of the pure copper sheet becoming locally coarse are suppressed, and it becomes possible to suppress the occurrence of poor bonding, poor appearance, or defects in the inspection step.

### Advantageous Effects of Invention

According to the present invention, it is possible to provide a pure copper sheet that is excellent in terms of hot workability and is capable of suppressing crystal grains becoming coarse and nonuniform even after a pressure heat treatment and a copper/ceramic bonded body and an insulated circuit substrate for which this pure copper sheet is used.

### BRIEF DESCRIPTION OF DRAWINGS

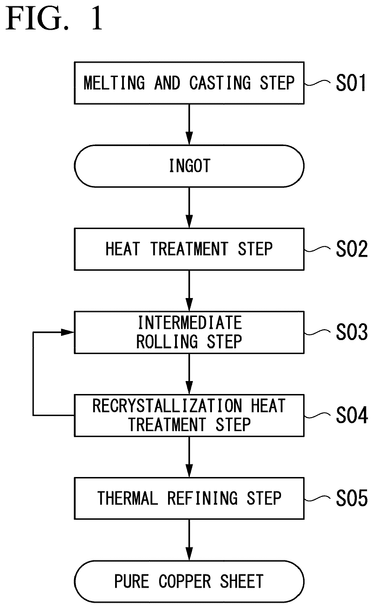

Fig. 1 is a flowchart of a method for manufacturing a pure copper sheet according to the present embodiment.

### DESCRIPTION OF EMBODIMENTS

Hereinafter, a pure copper sheet according to an embodiment of the present invention will be described.

A pure copper sheet, which is the present embodiment, is used as a material for electrical and electronic components such as heat sinks or thick copper circuits and is used in a state of being bonded to, for example, a ceramic substrate at the time of molding the above-described electrical and electronic components.

The pure copper sheet, which is the present embodiment, has a composition in which the Cu content is set to 99.96 mass% or more, the total content of Pb, Se, and Te is set to 10.0 mass ppm or less, the total content of Ag and Fe is set to 3.0 mass ppm or more, and the balance is inevitable impurities. Hereinafter, there are cases where "mass%" and "mass ppm" are each expressed as "%" and "ppm".

It should be noted that, in the pure copper sheet, which is the present embodiment, it is preferable that the content of S is set in a range of 2.0 mass ppm or more and 20.0 mass ppm or less.

In addition, in the pure copper sheet, which is the present embodiment, it is preferable that the total content of one or more selected from Mg, Sr, Ba, Ti, Zr, Hf, and Y (A element group) is 15.0 mass ppm or less.

In addition, in the pure copper sheet, which is the present embodiment, the average crystal grain size of crystal grains on a rolled surface is set to 10 µm or more, and the aspect ratios of the crystal grains on the rolled surface are set to 2.0 or less.

In addition, the average crystal grain size of the crystal grains on the rolled surface after a pressure heat treatment performed under the conditions of a pressure of 0.6 MPa, a heating temperature of 850°C, and a retention time at the heating temperature of 90 minutes is set to 500 µm or less.

The average crystal grain size of the crystal grains on the rolled surface can be, for example, the average value of the grain sizes of crystals that are measured at three or more places at equal distances from the center of the rolled surface.

It should be noted that, in the pure copper sheet, which is the present embodiment, it is preferable that the ratio dₘₐₓ/dₐᵥₑ of the maximum crystal grain size dₘₐₓ to the average crystal grain size dₐᵥₑ within a range of 50 mm × 50 mm after the pressure heat treatment is 20.0 or less. The maximum crystal grain size dₘₐₓ is preferably the largest one of the grain sizes of crystals measured in at least three places in a range that is a selected range with an arbitrary area of 50 mm × 50 mm.

In addition, in the pure copper sheet, which is the present embodiment, it is preferable that the Vickers hardness is 150 HV or less.

Here, the reasons for specifying the component composition and a variety of characteristics as described above in the pure copper sheet of the present embodiment will be described below.

### (Purity of Cu: 99.96 mass% or higher)

In electrical and electronic components for high-current uses, there is a demand for excellent conductivity and an excellent heat radiation in order to suppress the generation of heat during electrical conduction, and pure copper that is particularly excellent in terms of the conductivity and the heat radiation is preferably used. In addition, in the case of being bonded to a ceramic substrate or the like, it is preferable that the pure copper sheet has a small deformation resistance such that thermal strain generated during loading of thermal cycle can be relaxed.

Therefore, in the pure copper sheet, which is the present embodiment, the purity of Cu is specified as 99.96 mass% or higher.

It should be noted that the purity of Cu is preferably 99.965 mass% or higher and more preferably 99.97 mass% or higher. In addition, the upper limit of the purity of Cu is not particularly limited, but is preferably set to 99.999 mass% or lower since, in a case where the upper limit exceeds 99.999 mass%, a special refining step is required, and the manufacturing cost significantly increases.

### (Total content of Pb, Se, and Te: 10.0 mass ppm or less)

Pb, Se, and Te are elements that have a low solid solubility limit in Cu, have an action of suppressing the coarsening of crystal grains by being segregated in grain boundaries, and significantly degrade hot workability. Therefore, in the present embodiment, the total content of Pb, Se, and Te is limited to 10.0 mass ppm or less in order to ensure hot workability.

It should be noted that, in the case of further improving hot workability, the total content of Pb, Se, and Te is preferably set to 9.0 mass ppm or less and more preferably set to 8.0 mass ppm or less. In addition, in order to reliably suppress the coarsening of the crystal grains, the total content of Pb, Se, and Te is preferably set to 0.1 mass ppm or more, more preferably set to 0.2 mass ppm or more, and most preferably set to 0.3 mass ppm or more.

### (Total content of Ag and Fe: 3.0 mass ppm or more)

Ag and Fe are elements having an action of suppressing the coarsening of the crystal grains by forming solid solutions in the copper matrix.

Therefore, in a case where the total content of Ag and Fe is set to 3.0 mass ppm or more in the present embodiment, it is possible to make the crystal grain coarsening-suppressing effect of Ag and Fe sufficiently exhibited, and it becomes possible to reliably suppress the crystal grains becoming coarse even after the pressure heat treatment.

It should be noted that the lower limit of the total content of Ag and Fe is preferably 5.0 mass ppm or more, more preferably 7.0 mass ppm or more, and most preferably 10.0 mass ppm or more. In addition, since there is a concern that the addition of the element more than necessary may cause an increase in the manufacturing cost or a decrease in the electrical conductivity, the upper limit of the total content of Ag and Fe is preferably less than 100.0 mass ppm, more preferably less than 50.0 mass ppm, and most preferably less than 20.0 mass ppm.

### (Content of S: 2.0 mass ppm or more and 20.0 mass ppm or less)

S is an element that has an action of suppressing the coarsening of the crystal grains by suppressing the movement of crystal grain boundaries and degrades hot workability.

Therefore, in a case where the content of S is set to 2.0 mass ppm or more in the present embodiment, it is possible for the crystal grain coarsening-suppressing effect of S to be sufficiently exhibited, and it becomes possible to reliably suppress crystal grains becoming coarse even after the pressure heat treatment. On the other hand, in a case where the content of S is limited to 20.0 mass ppm or less, it becomes possible to ensure hot workability.

It should be noted that the lower limit of the content of S is preferably 2.5 mass ppm or more and more preferably 3.0 mass ppm or more. In addition, the upper limit of the content of S is preferably 17.5 mass ppm or less and more preferably 15.0 mass ppm or less.

### (Total content of Mg, Sr, Ba, Ti, Zr, Hf, Y (A element group): 15.0 mass ppm or less)

There is a concern that Mg, Sr, Ba, Ti, Zr, Hf, and Y (A element group) that are contained as inevitable impurities may generate a compound with the crystal grain coarsening-suppressing element that suppresses the coarsening of the crystal grains by being segregated in the crystal grain boundaries (S, Se, Te, or the like) and may impair the action of the crystal grain coarsening-suppressing elements.

Therefore, in order to reliably suppress the coarsening of crystal grains after the pressure heat treatment, the total content of Mg, Sr, Ba, Ti, Zr, Hf, and Y (A element group) is preferably set to 15.0 mass ppm or less.

It should be noted that the total content of Mg, Sr, Ba, Ti, Zr, Hf, and Y (A element group) is preferably 10.0 mass ppm or less, more preferably 7.5 mass ppm or less, and most preferably 5.0 mass ppm or less.

### (Other elements)

It should be noted that Al, Cr, Sn, P, Be, Cd, Mg, and Ni (M element group) have an effect of suppressing grain growth by the formation of solid solutions in the copper matrix, segregation in the grain boundaries, and, furthermore, the formation of oxides.

Therefore, in order to reliably suppress the coarsening of the crystal grains after the pressure heat treatment, more than 2.0 mass ppm of Al, Cr, Sn, P, Be, Cd, Mg, and Ni (M element group) in total are preferably contained. It should be noted that, in the case of intentionally containing Al, Cr, Sn, P, Be, Cd, Mg, and Ni (M element group), the lower limit of the total content of Al, Cr, Sn, P, Be, Cd, Mg, and Ni (M element group) is more preferably set to 2.1 mass ppm or more, still more preferably set to 2.3 mass ppm or more, far still more preferably set to 2.5 mass ppm or more, and optimally set to 3.0 mass ppm or more.

On the other hand, when Al, Cr, Sn, P, Be, Cd, Mg, and Ni (M element group) are contained more than necessary, since there is a concern that the electrical conductivity may decrease, the upper limit of the total content of Al, Cr, Sn, P, Be, Cd, Mg, and Ni (M element group) is preferably set to less than 100.0 mass ppm, more preferably set to less than 50.0 mass ppm, far more preferably less than 20.0 mass ppm, and still far more preferably set to less than 10.0 mass ppm.

### (Other inevitable impurities)

As other inevitable impurities other than the above-described elements, B, Bi, Ca, Sc, rare earth elements, V, Nb, Ta, Mo, W, Mn, Re, Ru, Os, Co, Rh, Ir, Pd, Pt, Au, Zn, Hg, Ga, In, Ge, As, Sb, Tl, N, C, Si, Li, H, O, and the like are exemplary examples. It is preferable to reduce these inevitable impurities since there is a concern that the inevitable impurities may decrease the electrical conductivity.

### (Average crystal grain size of crystal grains on rolled surface: 10 µm or more)

In the pure copper sheet, which is the present embodiment, when the average crystal grain size of the crystal grains on the rolled surface is fine, when a pressure heat treatment has been performed on this pure copper sheet, recrystallization is likely to proceed, and there is a concern that the growth of the crystal grains and the structure becoming nonuniform may be accelerated.

Therefore, in order to further suppress the coarsening of the crystal grains, the average crystal grain size of the crystal grains on the rolled surface is preferably set to 10 µm or more.

It should be noted that the average crystal grain size of the crystal grains on the rolled surface is preferably 15 µm or more and more preferably 20 µm or more.

### (Aspect ratios of crystal grains on rolled surface: 2.0 or less)

The aspect ratios of the crystal grains are an index that indicates the degree of working of a material. As the aspect ratio increases, the degree of working becomes higher, and the strain energy accumulated in the material becomes higher. Here, when the strain energy accumulated in the material is high, the driving force at the time of causing recrystallization becomes high, and the crystal grains are likely to become coarse during the pressure heat treatment.

Therefore, in order to further suppress the coarsening of the crystal grains, the aspect ratios of the crystal grains on the rolled surface are preferably set to 2.0 or less. The value of the aspect ratio herein is expressed as a value obtained by dividing the major axis by the minor axis, that is, major axis/minor axis.

It should be noted that the aspect ratios of the crystal grains on the rolled surface are preferably 1.9 or less and more preferably 1.8 or less.

### (Average grain size of crystal grains on rolled surface after pressure heat treatment: 500 µm or less)

When a heat treatment is performed by applying pressure, the coarsening of crystal progresses due to the increase in pressure, and the crystal grains of copper become locally coarse depending on the conditions for pressurization.

Therefore, in the present embodiment, the average crystal grain size of the crystal grains on the rolled surface after the pressure heat treatment under the conditions of a pressure of 0.6 MPa, a heating temperature of 850°C, and a retention time at the heating temperature of 90 minutes is limited to 500 µm or less, whereby it is possible to reliably suppress the coarsening of the crystal grains even in a case where the pressure heat treatment has been performed under the above-described conditions, and the pure copper sheet is particularly suitable as a material for thick copper circuits or heat sinks that are bonded to ceramic substrates.

It should be noted that the upper limit of the average crystal grain size of the crystal grains on the rolled surface after the pressure heat treatment is preferably 450 µm or less and more preferably 400 µm or less.

On the other hand, the lower limit of the average crystal grain size of the crystal grains on the rolled surface after the above-described pressure heat treatment is not particularly limited, but substantially becomes 50 µmor more.

### (Ratio dₘₐₓ/dₐᵥₑ of maximum crystal grain size dₘₐₓ to average crystal grain size dₐᵥₑ in range of 50 mm × 50 mm after pressure heat treatment: 20 or less)

In the pure copper sheet, which is the present embodiment, in a case where the ratio dₘₐₓ/dₐᵥₑ of the maximum crystal grain size dₘₐₓ to the average crystal grain size dₐᵥₑ within a range of 50 mm × 50 mm on the rolled surface after the pressure heat treatment under the conditions of a pressure of 0.6 MPa, a heating temperature of 850°C, and a retention time at the heating temperature of 90 minutes is 20 or less, it is possible to reliably suppress the crystal grains becoming nonuniform even in a case where the pressure heat treatment has been performed, and the pure copper sheet is particularly suitable as a material for thick copper circuits or heat sinks that are bonded to ceramic substrates.

It should be noted that the ratio dₘₐₓ/dₐᵥₑ of the maximum crystal grain size dₘₐₓ to the average crystal grain size dₐᵥₑ in a range of 50 mm × 50 mm after the above-described pressure heat treatment is more preferably 15.0 or less.

### (Vickers hardness: 150 HV or less)

In the pure copper sheet, which is the present embodiment, when the Vickers hardness is set to 150 HV or less, characteristics as a pure copper sheet are ensured, and the pure copper sheet is particularly suitable as a material for electrical and electronic components for high-current uses. In addition, the pure copper sheet is sufficiently soft, and, even in a case where the pure copper sheet is bonded to a different member such as a ceramic substrate and loaded with a thermal cycle, thermal strain generated by the deformation of the pure copper sheet is relaxed, and it becomes possible to suppress the cracking or the like of the ceramic substrate or the like.

It should be noted that the Vickers hardness of the pure copper sheet is more preferably 140 HV or less, still more preferably 130 HV or less, and most preferably 110 HV or less. The lower limit of the Vickers hardness of the pure copper sheet is not particularly limited; however, in a case where the hardness is too low, since the pure copper sheet is likely to deform during manufacturing and becomes hard to handle, the Vickers hardness is preferably 30 HV or more, more preferably 45 HV or more, and most preferably 60 HV or more.

Next, a method for manufacturing the pure copper sheet, which is the present embodiment configured as described above, will be described with reference to a flowchart shown in Fig. 1.

### (Melting and casting step S01)

First, the above-described elements are added to molten copper obtained by melting an oxygen-free copper raw material to adjust components, and a molten copper alloy is produced. It should be noted that, for the addition of a variety of elements, a pure element, a mother alloy, or the like can be used. In addition, a raw material containing the above-described elements may be melted together with the copper raw material. Here, the molten copper is preferably so-called 4NCu having a purity of 99.99 mass% or more or so-called 5NCu having a purity of 99.999 mass% or more.

In the melting step, atmosphere melting using an inert gas atmosphere in which the vapor pressure of H₂O is low (for example, Ar gas) is performed in order to decrease the hydrogen concentration, and the retention time during melting is preferably kept to the minimum. In addition, the molten copper alloy having an adjusted component is injected into a casting mold to produce an ingot. It should be noted that, in the case of taking mass production into account, a continuous casting method or a semi-continuous casting method is preferably used.

### (Heat treatment step S02)

The obtained ingot is cut, and the surface is ground to remove scale. After that, a heat treatment is performed for homogenization and the formation of a solution. Here, the heat treatment conditions are not particularly limited; however, preferably, in order to suppress the generation of a precipitate, it is preferable to perform the heat treatment at a heat treatment temperature in a range of 500°C or higher and 900°C or lower for a retention time at the heat treatment temperature in a range of 0.1 hour or longer and 100 hours or shorter in a non-oxidizing or reducing atmosphere. In addition, the cooling method is not particularly limited, but it is preferable to select a method in which the cooling rate becomes 200 °C/min or faster such as water quenching.

In addition, in order to make the structure uniform, hot working may be performed after the heat treatment. The working method is not particularly limited; however, in a case where the final form is a sheet or a strip, rolling is adopted. Alternatively, forging, pressing, or groove rolling may be adopted. The temperature during the hot working is also not particularly limited, but is preferably set in a range of 500°C or higher and 900°C or lower. In addition, the total working rate of the hot working is preferably set to 50% or more, more preferably set to 60% or more, and still more preferably 70% or more.

### (Intermediate rolling step S03)

Next, cold rolling is performed on the copper material that has been subjected to the heat treatment step S02 to work the copper material into a predetermined shape. It should be noted that the temperature condition in the intermediate rolling step S03 is not particularly limited, but the intermediate rolling step is preferably performed in a range of -200°C or higher and 200°C or lower. In addition, the working rate in the intermediate rolling step S03 is appropriately selected so as to work the copper material into a shape similar to the final shape, and the working rate is preferably set to 30% or more in order to improve the productivity.

### (Recrystallization heat treatment step S04)

Next, a heat treatment is performed on the copper material that has been subjected to the intermediate rolling step S03 for the objective of recrystallization. Here, the average crystal grain size of recrystallized grains on the rolled surface is set to 10 µm or more. When the recrystallized grains are fine, there is a concern that, when a pressure heat treatment is performed afterwards, the growth of the crystal grains and the structure becoming nonuniform may be accelerated.

The heat treatment conditions in the recrystallization heat treatment step S04 are not particularly limited, but the copper material is preferably held at a heat treatment temperature in a range of 200°C or higher and 900°C or lower for a range of 1 second or longer and 10 hours or shorter. For example, in a short-time heat treatment, the copper material may be held at 850°C for 5 seconds, and, in a long-time heat treatment of 1 hour or longer, the copper material may be held at 400°C for 8 hours.

In addition, in order to make the recrystallization structure uniform, the intermediate rolling step S03 and the recrystallization heat treatment step S04 may be repeated twice or more.

### (Temper rolling step S05)

Next, temper rolling may be performed on the copper material that has been subjected to the recrystallization heat treatment step S04 in order to adjust the material strength. It should be noted that, in a case where there is no need to increase the material strength, temper rolling may not be performed.

The working rate of temper rolling is not particularly limited, but temper rolling is preferably performed at a working rate in a range of more than 0% and 50% or less in order to set the aspect ratios of the crystal grains on the rolled surface to 2.0 or less and to set the Vickers hardness to 150 HV or less, and the working rate is more preferably limited to more than 0% and 40% or less.

In addition, if necessary, a heat treatment may be further performed after the temper rolling in order to remove residual strain. The final thickness is not particularly limited, but is preferably, for example, in a range of 0.5 mm or more and 5 mm or less.

The pure copper sheet, which is the present embodiment, is produced by each of the above-described steps.

According to the pure copper sheet, which is the present embodiment configured as described above, since the pure copper sheet has a composition in which the Cu content is set to 99.96 mass% or more, the total content of Pb, Se, and Te is set to 10.0 mass ppm or less, the total content of Ag and Fe is set to 3.0 mass ppm or more, and the balance is inevitable impurities, it becomes possible to suppress the coarsening of crystal grains by the formation of solid solutions of Ag and Fe in the matrix of copper. In addition, Pb, Se, and Te are crystal grain growth-suppressing elements that are segregated in grain boundaries to suppress the coarsening of crystal grains and thus may be contained in a small amount, but these elements significantly degrade hot workability. Therefore, when the total content of these Pb, Se, and Te is limited to 10.0 mass ppm or less, it is possible to ensure hot workability.

In addition, in the pure copper sheet, which is the present embodiment, since the average crystal grain size of the crystal grains on the rolled surface is 10 µm or more and the aspect ratios of the crystal grains on the rolled surface are set to 2.0 or less, before a pressure heat treatment, the grain sizes are relatively large, and the residual strain is little, and thus the driving force for recrystallization during a pressure heat treatment is small, and it becomes possible to suppress grain growth.

In addition, in the pure copper sheet, which is the present embodiment, since the average crystal grain size of the crystal grains on the rolled surface after a pressure heat treatment performed under the conditions of a pressure of 0.6 MPa, a heating temperature of 850°C, and a retention time at the heating temperature of 90 minutes is limited to 500 µm or less, crystal growth after the pressure heat treatment is reliably suppressed, and it is possible to suppress the occurrence of poor bonding or poor appearance when bonded to other members.

In addition, in the present embodiment, in a case where the content of S is set in a range of 2.0 mass ppm or more and 20.0 mass ppm or less, S, which is one kind of crystal grain growth-suppressing element, is segregated in the grain boundaries, and it becomes possible to reliably suppress the crystal grains becoming coarse and nonuniform during the pressure heat treatment. In addition, it is possible to ensure hot workability.

Furthermore, in the present embodiment, in a case where the total content of Mg, Sr, Ba, Ti, Zr, Hf, and Y (A element group) is 15.0 mass ppm or less, it is possible to suppress these elements of the A element group and S, Se, Te, and the like, which are crystal grain growth-suppressing elements, reacting with each other to generate a compound, and it becomes possible to make the action of the crystal grain growth-suppressing elements sufficiently exhibited. Therefore, it becomes possible to reliably suppress the crystal grains becoming coarse and nonuniform during the pressure heat treatment.

Furthermore, in the present embodiment, in a case where the ratio dₘₐₓ/dₐᵥₑ of the maximum crystal grain size dₘₐₓ to the average crystal grain size dₐᵥₑ after the pressure heat treatment is set to 20.0 or less, it is possible to reliably suppress the crystal grains becoming nonuniform even after the pressure heat treatment.

In addition, in the present embodiment, in a case where the Vickers hardness is 150 HV or less, since the pure copper sheet is sufficiently soft, and characteristics as a pure copper sheet are ensured, the pure copper sheet is particularly suitable as a material for electrical and electronic components for high-current uses.

Furthermore, in the present embodiment, in a case where more than 2.0 mass ppm of Al, Cr, Sn, P, Be, Cd, Mg, and Ni (M element group) are contained, it becomes possible to more reliably suppress grain growth after the pressure heat treatment by the formation of solid solutions in the matrix, segregation in the grain boundaries, and, furthermore, the formation of oxides by the elements of the M element copper group.

Hitherto, the pure copper sheet, which is the embodiment of the present invention, has been described, but the present invention is not limited thereto and can be appropriately modified within the scope of the technical concept of the invention.

For example, in the above-described embodiment, an example of the method for manufacturing the pure copper sheet has been described, but the method for manufacturing the pure copper sheet is not limited to the manufacturing method described in the embodiment, and the pure copper sheet may be manufactured by appropriately selecting an existing manufacturing method.

### EXAMPLES

Hereinafter, the results of confirmatory experiments performed to confirm the effect of the present invention will be described.

A raw material made of pure copper having a purity of 99.999 mass% or higher and a mother alloy in which 1 mass% of a variety of elements was added to Cu were prepared, and these were charged into a high-purity graphite crucible and melted with a high frequency in an atmosphere furnace in which an Ar gas atmosphere was formed. In the obtained molten copper, a variety of 1 mass% mother alloys produced using high-purity copper of 6N (purity: 99.9999 mass% or higher) and a pure metal having a purity of 2N (purity: 99 mass% or higher) were used to prepare a predetermined component composition, and the obtained molten copper was poured into a casting mold to produce an ingot. It should be noted that the sizes of the ingot were set to a thickness of approximately 80 mm, a width of approximately 100 mm, and a length of approximately 150 to 200 mm.

The obtained ingots were heated in an Ar gas atmosphere for 1 hour under the temperature conditions shown in Tables 1 and 2 and hot-rolled to a thickness of 40 mm.

The copper materials after hot rolling were cut, and surface grinding was performed to remove oxide films on the surfaces. At this time, the thicknesses of the copper materials to be subjected to cold rolling were adjusted such that the final thicknesses became as shown in Tables 1 and 2 in consideration of the rolling rates of subsequent cold rolling and temper rolling.

The copper materials having a thickness adjusted as described above were subjected to cold rolling under the conditions shown in Tables 1 and 2 and water cooling.

Next, on the copper materials that had been subjected to the cold rolling, a recrystallization heat treatment was performed under the conditions shown in Tables 1 and 2.

In addition, on the copper materials that had been subjected to the recrystallization heat treatment, temper rolling was performed under the conditions shown in Tables 1 and 2, thereby manufacturing strip materials for characteristic evaluation having a thickness shown in Tables 1 and 2 and a width of 60 mm.

In addition, evaluation was performed regarding the following items.

### (Composition analysis)

A measurement specimen was collected from the obtained ingot, S was measured by the infrared absorption method, and other elements were measured using a glow discharge mass spectrometer (GD-MS). It should be noted that the measurement was performed at two sites, the central portion of the specimen and an end portion in the width direction, and a larger content was regarded as the content of the sample. The measurement results are shown in Tables 1 and 2.

### (Evaluation of workability)

As the evaluation of the workability, the presence or absence of a cracked edge during the above-described hot rolling and cold rolling was observed. A specimen from which a cracked edge was not or rarely recognized visually was evaluated as "A", a specimen in which a cracked edge as small as a length of less than 1 mm was generated was evaluated as "B", and a specimen in which a cracked edge of a length of 1 mm or more was generated was evaluated as "C". The evaluation results are shown in Tables 3 and 4.

It should be noted that the length of the cracked edge is the length of the cracked edge from an end portion in the width direction to the central portion in the width direction of the rolled material.

### (Vickers hardness)

The Vickers hardness was measured at a test load of 0.98 N in accordance with the micro Vickers hardness test method specified in JIS Z 2244. It should be noted that the measurement position was the rolled surface of the test piece for characteristic evaluation. The evaluation results are shown in Tables 3 and 4.

### (Electrical conductivity)

A test piece having a width of 10 mm and a length of 60 mm was collected from the strip material for characteristic evaluation, and the electric resistance was obtained by the 4-terminal method. In addition, the dimensions of the test piece were measured using a micrometer, and the volume of the test piece was calculated. In addition, the electrical conductivity was calculated from the measured electric resistance value and the measured volume. The evaluation results are shown in Tables 3 and 4.

It should be noted that the test piece was collected such that the longitudinal direction of the test piece became parallel to the rolling direction of the strip material for characteristic evaluation.

### (Average crystal grain size before pressure heat treatment)

A 20 mm × 20 mm sample was cut out from the obtained strip material for characteristic evaluation, and the average crystal grain size was measured with a SEM-EBSD (Electron Backscatter Diffraction Patterns) measuring instrument.

A rolled surface was mechanically polished using waterproof abrasive paper and diamond abrasive grains, and then finish-polished using a colloidal silica solution. After that, individual measurement points (pixels) in a measurement range on the specimen surface were irradiated with electron beams using an electron scanning microscope, and, by orientation analysis by backscatter electron diffraction, a region between adjacent measurement points where the orientation angle between the measurement points became 15° or more was regarded as a large-angle grain boundary, and a region where the orientation angle was less than 15° was regarded as a small-angle grain boundary. A crystal grain boundary map was produced using the large-angle grain boundaries, according to a cutting method of JIS H 0501, 5 vertical line segments having a predetermined length and 5 horizontal line segments having a predetermined length were drawn on the crystal grain boundary map, the number of crystal grains that were fully cut was counted, and the average value of the cut lengths was described as the average crystal grain size before the pressure heat treatment. The evaluation results are shown in Tables 3 and 4.

### (Aspect ratios of crystal grains)

For the aspect ratios of the crystal grains on the rolled surface, a crystal grain boundary map of the rolled surface of the above-described strip material for characteristic evaluation was produced using the SEM-EBSD (Electron Backscatter Diffraction Patterns) measuring instrument in the same manner as described above. Five line segments were drawn in the sheet width direction and five line segments were drawn in the rolling direction on the map, and the number of crystal grains that were completely cut was counted. The crystal grain size obtained in the rolling direction was defined as the major axis, and the crystal grain size obtained from the sheet width direction was defined as the minor axis, whereby the average value of the aspect ratios, which were the length ratios of the major axis to the minor axis, was calculated and regarded as the aspect ratio of the crystal grains. It should be noted that the value of the aspect ratio herein is expressed as a value obtained by dividing the major axis by the minor axis, that is, major axis/minor axis. The evaluation results are shown in Tables 3 and 4.

### (Average crystal grain size after pressure heat treatment)

A 50 mm × 50 mm sample was cut out from the above-described strip material for characteristic evaluation, the above-described sample (pure copper sheet) was sandwiched by two ceramic substrates (material: Si₃N₄, 50 mm × 50 mm × 1 mm in thickness), and a heat treatment was performed in a state where a load of a pressure of 0.6 MPa was applied. As the heat treatment, each ceramic substrate was injected into a furnace at 850°C, held for 90 minutes after the fact that the material temperature reached 850°C was confirmed with a thermocouple, and cooled in the furnace until the material temperature reached room temperature after the end of heating. After the temperature dropped to room temperature, the average crystal grain size was measured on the rolled surface of the pure copper sheet. The rolled surface was mechanically polished using waterproof abrasive paper and diamond abrasive grains and then finish-polished using a colloidal silica solution. After that, the rolled surface was etched, in accordance with the cutting method of JIS H 0501, 5 vertical line segments having a predetermined length and 5 horizontal line segments having a predetermined length were drawn, the number of crystal grains that were fully cut was counted, and the average value of the cut lengths was regarded as the average crystal grain size. The evaluation results are shown in Tables 3 and 4.

### (Dispersion in grain size after pressure heat treatment)

As described above, in a sample collected from a test piece on which a pressure heat treatment had been performed, when the average value of the major axis of the most coarse crystal grain in a range of 50 mm × 50 mm except for twin crystals and the minor axis that was cut by grain boundaries at the time of drawing a line perpendicular to the major axis was defined as the maximum crystal grain size dₘₐₓ, a case where the ratio dₘₐₓ/dₐᵥₑ of this maximum crystal grain size to the above-described average crystal grain size dₐᵥₑ was 15.0 or less was evaluated as "A", a case where dₘₐₓ/dₐᵥₑ was more than 15.0 and 20.0 or less was evaluated as "B", and a case where dₘₐₓ/dₐᵥₑ exceeded 20.0 was evaluated as "C". The evaluation results are shown in Tables 3 and 4.

**[Table 1]**

| | | Component composition (mass ratio) | | | | | | Manufacturing steps | | | | | Thickness mm |
|---|---|---|---|---|---|---|---|---|---|---|---|---|---|
| | | Cu % | S ppm | Ag + Fe ppm | Pb + Se +Te ppm | A element group ppm | M element group ppm | Hot rolling | Intermediate working | Recryslallization heat treatment | | Temper rolling | |
| | | | | | | | | Temperature °C | Rolling rate % | Temperature °C | Time See | Rolling rate % | |
| | 1 | 99.96 or more | 4.5 | 10.2 | 3.8 | 4.2 | 2.3 | 900 | 90 | 700 | 5 | 13 | 1.5 |
| | 2 | 99.96 or more | 5.1 | 10.6 | 8.2 | 4.1 | 2.2 | 900 | 90 | 650 | 180 | 40 | 1.0 |
| | 3 | 99.96 or more | 5.2 | 10.3 | 9.1 | 4.4 | 2.9 | 900 | 90 | 350 | 3000 | 15 | 1.5 |
| | 4 | 99.96 or more | 4.9 | 10.2 | 9.9 | 4.4 | 2.5 | 900 | 90 | 400 | 600 | 10 | 0.5 |
| | 5 | 99.96 or more | 6.7 | 10.5 | 0.3 | 4.0 | 2.8 | 900 | 92 | 330 | 60 | 35 | 0.5 |
| | 6 | 99.96 or more | 3.9 | 9.6 | 1.0 | 4.6 | 3.0 | 900 | 94 | 370 | 10 | 30 | 0.5 |
| | 7 | 99.96 or more | 7.2 | 10.8 | 2.0 | 4.0 | 2.6 | 900 | 90 | 400 | 60 | 30 | 2.0 |
| | 8 | 99.96 or more | 5.6 | 11.2 | 3.5 | 4.9 | 2.3 | 900 | 90 | 420 | 60 | 0 | 2.0 |
| Present Invention Example | 9 | 99.96 or more | 6.9 | 11.2 | 3.0 | 4.2 | 2.8 | 900 | 90 | 450 | 10 | 5 | 1.5 |
| | 10 | 99.96 or more | 5.0 | 10.1 | 3.0 | 4.8 | 2.6 | 900 | 90 | 430 | 300 | 40 | 0.5 |
| | 11 | 99.96 or more | 6.9 | 10.3 | 2.5 | 4.5 | 2.9 | 900 | 90 | 400 | 1800 | 47 | 1.0 |
| | 12 | 99.96 or more | 6.6 | 10.5 | 2.9 | 3.1 | 3.0 | 900 | 90 | 400 | 300 | 51 | 1.0 |
| | 13 | 99.96 or more | 0.2 | 9.7 | 2.7 | 4.4 | 2.2 | 900 | 90 | 400 | 300 | 40 | 1.0 |
| | 14 | 99.96 or more | 2.1 | 9.8 | 3.3 | 4.6 | 2.8 | 900 | 90 | 420 | 180 | 42 | 1.0 |
| | 15 | 99.96 or more | 2.6 | 11.2 | 3.2 | 4.8 | 3.1 | 900 | 90 | 430 | 10 | 40 | 1.0 |
| | 16 | 99.96 or more | 25.0 | 11.3 | 2.8 | 4.9 | 2.7 | 900 | 90 | 390 | 180 | 10 | 1.0 |
| | 17 | 99.96 or more | 18.9 | 10.5 | 3.4 | 4.9 | 2.6 | 900 | 90 | 450 | 300 | 15 | 1.5 |
| | 18 | 99.96 or more | 16.2 | 10.6 | 3.4 | 4.2 | 2.7 | 900 | 90 | 500 | 360 | 10 | 1.5 |

| | | | | | | | | | | | | | |
|---|---|---|---|---|---|---|---|---|---|---|---|---|---|
| A element group: One or more selected from Mg, Sr, Ba, Ti, Zr, Hf, and Y B element group: One or more selected from Al, Cr, Sn, P. Be, Cd, Mg, and Ni | | | | | | | | | | | | | |

**[Table 2]**

| | | Component composition (mass ratio) | | | | | | Manufacturing steps | | | | | Thickness mm |
|---|---|---|---|---|---|---|---|---|---|---|---|---|---|
| | | Cu % | S ppm | Ag + Fe ppm | Pb + Se + Te ppm | A element group ppm | M element group ppm | Hot rolling | Intermediate working | Recrystallization heat treatment | | Temper rolling | |
| | | | | | | | | Temperature °C | Rolling rate % | Temperature °C | Time Sec. | Rolling rate % | |
| | 19 | 99.96 or more | 3.5 | 10.2 | 3.1 | 7.3 | 2.7 | 900 | 90 | 350 | 600 | 35 | 1.0 |
| | 20 | 99.96 or more | 4.4 | 10.8 | 3.5 | 9.6 | 2.7 | 900 | 90 | 400 | 480 | 35 | 2.0 |
| | 21 | 99.96 or more | 4.7 | 10.7 | 3.0 | 15.4 | 2.8 | 900 | 90 | 400 | 360 | 40 | 0.5 |
| | 22 | 99.96 or more | 6.7 | 10.7 | 2.7 | 4.6 | 2.7 | 900 | 92 | 750 | 30 | 0 | 0.5 |
| | 23 | 99.96 or more | 9.1 | 10.9 | 2.7 | 4.8 | 2.6 | 900 | 92 | 390 | 60 | 0 | 2.0 |
| | 24 | 99.96 or more | 6.5 | 10.5 | 2.7 | 4.6 | 2.9 | 900 | 90 | 560 | 180 | 15 | 2.0 |
| Present Invention Example | 25 | 99.96 or more | 4.2 | 10.4 | 2.4 | 3.9 | 2.6 | 900 | 90 | 650 | 650 | 16 | 1.5 |
| | 26 | 99.96 or more | 5.5 | 10.3 | 3.0 | 4.4 | 2.6 | 900 | 88 | 550 | 10 | 20 | 1.0 |
| | 27 | 99.96 or more | 5.6 | 10.2 | 0 | 4.0 | 1.8 | 900 | 88 | 520 | 5 | 25 | 1.0 |
| | 28 | 99.96 or more | 4.5 | 3.3 | 3.3 | 3.9 | 2.8 | 900 | 90 | 550 | 10 | 10 | 1.0 |
| | 29 | 99.96 or more | 5.2 | 5.2 | 3.5 | 4.1 | 2.9 | 900 | 90 | 525 | 30 | 10 | 0.5 |
| | 30 | 99.96 or more | 5.3 | 7.6 | 3.6 | 3.9 | 2.6 | 900 | 90 | 550 | 10 | 10 | 1.0 |
| Comparative Example | 1 | 99.96 or more | 2.3 | 10.2 | 34.4 | 2.3 | 2.4 | 900 | 90 | - | - | - | - |
| | 2 | 99.96 or more | 2.5 | 10.3 | 2.0 | 2.8 | 2.1 | 900 | 95 | 350 | 5 | 55 | 0.5 |
| | 3 | 99.96 or more | 0.0 | 0.2 | 0.0 | 0.1 | 0.2 | 900 | 90 | 400 | 300 | 45 | 0.5 |

| | | | | | | | | | | | | | |
|---|---|---|---|---|---|---|---|---|---|---|---|---|---|
| A element group: One or more selected from Mg. Sr, Ba, Ti, Zr, Hf, and Y B element group: One or more selected from Al, Cr, Sn, P, Be, Cd, Mg, and Ni | | | | | | | | | | | | | |

**[Table 3]**

| | | Workability | Vickers hardness HV | Electrical conductivity %IACS | Before pressure heat treatment | | After pressure heat treatment | |
|---|---|---|---|---|---|---|---|---|
| | | | | | Crystal grain size µm | Aspect ratio | Crystal grain size µm | Dispersion in grain size |
| Present Invention Example | 1 | A | 78 | 99 | 35 | 1.2 | 180 | A |
| | 2 | B | 76 | 100 | 36 | 1.1 | 67 | A |
| | 3 | B | 81 | 100 | 40 | 1.2 | 79 | A |
| | 4 | B | 75 | 99 | 44 | 1.1 | 77 | A |
| | 5 | A | 95 | 99 | 11 | 1.6 | 487 | B |
| | 6 | A | 93 | 99 | 16 | 1.4 | 444 | A |
| | 7 | A | 91 | 99 | 22 | 1.4 | 398 | A |
| | 8 | A | 60 | 101 | 31 | 1.0 | 53 | A |
| | 9 | A | 63 | 101 | 26 | 1.1 | 62 | A |
| | 10 | A | 100 | 98 | 38 | 1.8 | 432 | A |
| | 11 | A | 124 | 98 | 23 | 1.9 | 483 | A |
| | 12 | A | 129 | 98 | 22 | 2.0 | 497 | A |
| | 13 | A | 105 | 99 | 19 | 1.6 | 482 | A |
| | 14 | A | 111 | 98 | 22 | 1.7 | 467 | A |
| | 15 | A | 109 | 98 | 25 | 1.7 | 451 | A |
| | 16 | B | 78 | 99 | 21 | 1.1 | 183 | A |
| | 17 | B | 81 | 99 | 35 | 1.2 | 195 | A |
| | 18 | B | 78 | 99 | 39 | 1.1 | 222 | A |

**[Table 4]**

| | | Workability | Vickers hardness IIV | Electrical conductivity %IACS | Before pressure heat treatment | | After pressure heat treatment | |
|---|---|---|---|---|---|---|---|---|
| | | | | | Crystal grain size µm | Aspect ratio | Crystal grain size µm | Dispersion in grain size |
| Present Invention Example | 19 | A | 86 | 98 | 33 | 1.5 | 432 | A |
| | 20 | A | 87 | 98 | 39 | 1.6 | 455 | A |
| | 21 | A | 114 | 98 | 40 | 1.7 | 477 | A |
| | 22 | A | 53 | 102 | 52 | 1.0 | 69 | A |
| | 23 | A | 59 | 102 | 25 | 1.0 | 60 | A |
| | 24 | A | 82 | 100 | 36 | 1.2 | 125 | A |
| | 25 | A | 79 | 100 | 45 | 1.2 | 209 | A |
| | 26 | A | 84 | 100 | 23 | 1.3 | 334 | A |
| | 27 | A | 84 | 99 | 20 | 1.3 | 397 | A |
| | 28 | A | 74 | 99 | 42 | 1.1 | 263 | A |
| | 29 | A | 73 | 98 | 38 | 1.1 | 251 | A |
| | 30 | A | 75 | 98 | 49 | 1.1 | 221 | A |
| Comparative Example | 1 | D | - | - | - | - | - | - |
| | 2 | A | 113 | 98 | 8 | 2.2 | 632 | C |
| | 3 | A | 103 | 98 | 46 | 1.8 | 621 | C |

In Comparative Example 1, since the total content of Pb, Te, and Se was larger than the range of the present invention, the hot workability was poor. Subsequent evaluation was stopped since a large crack was initiated during hot working. In Comparative Example 2, since the aspect ratios of the crystal grains on the rolled surface were larger than the range of the present invention and the average crystal grain size was small, the crystal grains became coarse after the pressure heat treatment, and the dispersion in the grain size became large.

In Comparative Example 3, since the total content of Ag and Fe was smaller than the range of the present invention, the crystal grains became coarse after the pressure heat treatment, and the dispersion in the grain size became large.

In contrast, in Present Invention Examples 1 to 30, the average crystal grain sizes after the pressure heat treatment were small, and the dispersions in the grain size were small.

From the above-described results, it was confirmed that, according to the present invention examples, it is possible to provide a pure copper sheet that is excellent in terms of hot workability and is capable of suppressing crystal grains becoming coarse and nonuniform even after a pressure heat treatment.

## Claims

1. A pure copper sheet having a composition comprising:
99.96 mass% or more of Cu;
10.0 mass ppm or less of a total content of Pb, Se, and Te;
3.0 mass ppm or more of a total content of Ag and Fe; and
inevitable impurities as a balance,
wherein an average crystal grain size of crystal grains on a rolled surface is 10.0 µm or more, and an aspect ratio of the crystal grains on the rolled surface is 2.0 or less, and
an average crystal grain size of the crystal grains on the rolled surface after a pressure heat treatment is performed under conditions of a pressure of 0.6 MPa, a heating temperature of 850°C, and a retention time at the heating temperature of 90 minutes is 500 µm or less.

2. The pure copper sheet according to Claim 1,
wherein a content of S is in a range of 2.0 mass ppm or more and 20.0 mass ppm or less.

3. The pure copper sheet according to Claim 1 or 2,
wherein a total content of Mg, Sr, Ba, Ti, Zr, Hf, and Y is 15.0 mass ppm or less.

4. The pure copper sheet according to any one of Claims 1 to 3,
wherein a ratio dₘₐₓ/dₐᵥₑ of a maximum crystal grain size dₘₐₓ to an average crystal grain size dₐᵥₑ in a range of 50 mm × 50 mm on the rolled surface after the pressure heat treatment is performed is 20.0 or less.

5. The pure copper sheet according to any one of Claims 1 to 4,
wherein a Vickers hardness is 150 HV or less.

6. A copper/ceramic bonded body comprising:
the pure copper sheet according to any one of Claims 1 to 5; and
a ceramic member, the pure copper sheet and the ceramic member being bonded each other.

7. An insulated circuit substrate comprising:
the pure copper sheet according to any one of Claims 1 to 5 bonded to a surface of a ceramic substrate.
